# DEMANDE DE BREVET EUROPEEN

(11) **EP 2 043 135 A1**
(43) Date de publication de la demande: **01.04.2009**
(21) Numéro de dépôt: 08165013.7
(22) Date de dépôt: 24.09.2008
(51) Int. Cl.: H01L 21/20

(54) **Procèdè de fabrication de structures semicondutrices utiles pour la réalisation de substrats semiconducteur-sur-isolant, et ses applications**

(30) Priorité: 25.09.2007 FR 0757828
(71) Demandeur: Commissariat à l'Energie Atomique, 75015 Paris (FR)
(72) Inventeur: Hartmann, Jean-Michel, 38420, LE VERSOUD (FR); Vandroux, Laurent, 38570, LE CHEYLAS (FR)
(74) Mandataire: Ilgart, Jean-Christophe

(57) **Abrégé**

L'invention se rapporte à un procédé de fabrication d'une structure semiconductrice, qui comprend :
une étape a) de fourniture d'un substrat de Si ayant une face avant et une face arrière, et
une étape b) qui comprend le dépôt par épitaxie, sur la face avant du substrat de Si, d'une couche épaisse de Ge, d'un substrat virtuel de SiGe ou d'un empilement comprenant au moins une couche épaisse de Ge ou au moins un substrat virtuel de SiGe,
et qui est **caractérisé en ce qu**'il comprend en outre le dépôt, sur la face arrière du substrat de Si, d'une couche ou d'une pluralité de couches générant sur cette face arrière des contraintes de flexion qui compensent les contraintes de flexion s'exerçant sur la face avant dudit substrat à l'issue de l'étape b).

L'invention se rapporte également à un procédé de fabrication de substrats semiconducteur-sur-isolant mettant en oeuvre le procédé ci-dessus.

Applications : microélectronique et optoélectronique.

## Description

### DOMAINE TECHNIQUE

La présente invention se rapporte à un procédé permettant de fabriquer des structures semiconductrices qui sont constituées d'un empilement comprenant au moins un substrat virtuel de silicium-germanium ou au moins une couche épaisse de germanium sur un substrat de silicium et qui sont néanmoins exemptes de toute courbure.

De telles structures semiconductrices sont utiles comme produits intermédiaires notamment dans la réalisation de substrats semiconducteur-sur-isolant destinés à la microélectronique ou à l'optoélectronique et comprenant soit une couche de silicium contraint (sSOI ou XsSOI), soit une couche de germanium contraint (sGeOI) ou non contraint (GeOI), soit encore une couche de silicium-germanium contraint (sSiGeOI) ou non contraint (SiGeOI).

La présente invention se rapporte donc également à un procédé de fabrication de substrats semiconducteur-sur-isolant qui met en oeuvre ce procédé de fabrication de structures semiconductrices.

### DEFINITIONS

Dans ce qui précède et ce qui suit, on entend par « substrat virtuel de silicium-germanium », un substrat formé par l'empilement :
■ d'une première couche qui est une couche de silicium-germanium à gradient de concentration croissante en germanium, ce gradient pouvant aller de 0 à 100% de germanium avec typiquement une rampe de l'ordre de 5 à 20% et, le plus souvent, de 10% de Ge par µm d'épaisseur ; et
■ d'une deuxième couche qui est soit une couche de silicium-germanium de composition constante et dont la concentration en germanium est au moins égale à la concentration maximale en germanium de la première couche, soit une couche de germanium pur, cette deuxième couche présentant généralement une épaisseur de l'ordre de 1 à 2 µm et étant quasiment totalement relaxée et relativement exempte de dislocations émergentes (c'est-à-dire de défauts qui traversent l'épaisseur de la couche pour émerger en surface), néfastes aux propriétés de transport électronique.

Les conditions de croissance par épitaxie de ce type d'empilements sur des substrats de silicium et leurs propriétés structurales sont bien connues de l'homme du métier. Elles ont notamment été décrites par Y. Bogumilowicz et al. dans Journal of Crystal Growth (274, 28-37, 2005 **[1]** ; 283, 346-55, 2005 **[2]** ; 290, 523-31, 2006 **[3]**) et dans Solid State Phenomena (108-109, 445, 2005 **[4]**) ainsi que par D. M. Isaacson et al. dans Journal of Vacuum Science and Technology B 24, 2741-46, 2006 **[5].**

On entend par « couche épaisse de germanium », une couche de germanium pur d'épaisseur allant de 0,1 à 10 µm, et en particulier de 0,2 à 6 µm, cette couche étant obtenue typiquement par un procédé qui comprend la croissance par épitaxie d'une couche de germanium à basse température (de l'ordre de 330 à 450°C), suivie de la croissance d'une couche de germanium à haute température (de l'ordre de 600 à 850°C), complétées le cas échéant par un cyclage thermique pour diminuer la densité des dislocations émergentes.

Là également, les conditions de croissance par épitaxie de ce type de couches sur des substrats de silicium et leurs propriétés structurales sont bien connues de l'homme du métier qui pourra se référer, si nécessaire, aux articles publiés par J. M. Hartmann et al. dans Journal of Crystal Growth 274, 90, 2005 **[6],** et L. Clavelier et al. dans ECS Transactions 3(7), 789, 2006 6 **[7].**

Par ailleurs, on considère qu'un matériau (Si, Ge ou SiGe) est « contraint » lorsque sa structure cristallographique est contrainte en tension ou en compression lors d'une croissance cristalline, par épitaxie, obligeant au moins un paramètre de maille à être différent du paramètre de maille nominal de ce matériau.

A l'inverse, on considère qu'il est « non contraint » ou « relaxé » lorsqu'il a une structure cristallographique non contrainte, c'est-à-dire qui présente un paramètre de maille identique au paramètre de maille nominal de ce matériau.

### ÉTAT DE LA TECHNIQUE ANTÉRIEURE

Les substrats virtuels de silicium-germanium et les couches épaisses de germanium tels que précédemment définis sont utilisés comme matières premières dans la fabrication de substrats semiconducteur-sur-isolant de type sSOI, XsSOI, GeOI ou analogues.

Le dépôt par épitaxie d'un substrat virtuel de silicium-germanium sur un substrat de silicium se traduit par une courbure de l'ensemble de la structure obtenue, courbure qui peut être soit légèrement convexe, soit plus ou moins concave selon la concentration en germanium des deux couches formant ce substrat virtuel.

De manière similaire, on observe, après dépôt par épitaxie d'une couche épaisse de germanium sur un substrat de silicium, une courbure concave de l'ensemble de la structure résultant de ce dépôt.

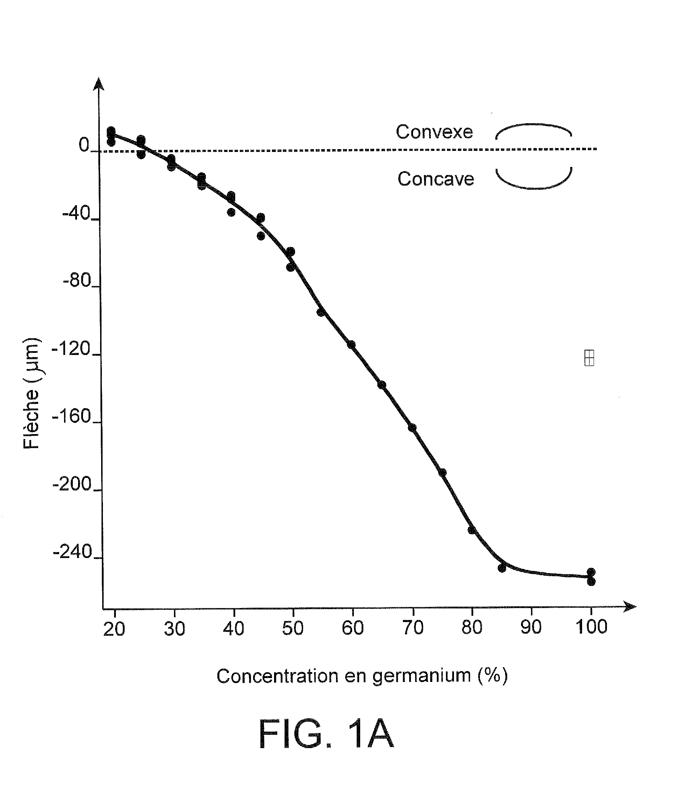

A titre d'exemple, la figure 1A représente, sous la forme d'une courbe, la taille, exprimée en µm, des flèches des courbures présentées par des structures constituées par un substrat virtuel de silicium-germanium formé par épitaxie directement sur un substrat de Si(001), en fonction de la concentration en germanium, exprimée en %, de la couche de composition constante située au sommet de ce substrat virtuel et, sous la forme d'une croix, la taille, également exprimée en µm, des flèches des courbures présentées par des structures constituées par une couche épaisse de germanium de 2,3 µm d'épaisseur, formée par épitaxie directement sur un substrat de Si(001).

Ces courbures sont dues au fait que, dans la plupart des équipements industriels d'épitaxie (tels que des bâtis de dépôt chimique en phase vapeur, pression réduite, etc), les plaques de silicium sur lesquelles sont déposés les substrats virtuels de silicium-germanium ou les couches épaisses de germanium reposent à plat sur une assiette de support. De ce fait, la croissance des couches ne se fait que sur la seule face des plaques de silicium qui est exposée au flux de gaz ou d'atomes, d'où l'existence d'une forte asymétrie entre les deux faces des plaques obtenues in fine.

Des courbures trop importantes, telles que celles que l'on observe, par exemple, dans le cas du dépôt par épitaxie de substrats virtuels de silicium-germanium dont la couche de composition constante présente une concentration en germanium de 30% ou plus, rendent difficile, voire impossible, l'utilisation de telles plaques pour un report ultérieur de couches sur un substrat de silicium oxydé, notamment par le procédé Smart Cut^{®}, en vue de l'obtention de substrats semiconducteur-sur-isolant de type sSOI, XsSOI, GeOI, sGeOI ou analogues.

Les Inventeurs se sont donc fixé pour but de fournir un procédé de fabrication de structures semiconductrices qui, bien qu'impliquant le dépôt par épitaxie de couches épaisses de germanium ou de substrats virtuels de silicium-germanium sur des substrats de silicium, permette néanmoins d'obtenir des structures exemptes de toute courbure.

Les Inventeurs se sont de plus fixé pour but que ce procédé soit simple à mettre en oeuvre, n'utilise que des techniques compatibles avec les procédés de production industrielle en usage dans le domaine de la microélectronique et de l'optoélectronique, et puisse être entièrement mis en oeuvre dans un bâti d'épitaxie.

Ils se sont encore fixé pour but que ce procédé ne génère pas de pollution métallique desdites couches épaisses de germanium ou desdits substrats virtuels de silicium-germanium, une telle pollution étant, en effet, incompatible avec une utilisation des structures en microélectronique.

### EXPOSÉ DE L'INVENTION

Ce but et d'autres encore sont atteints par l'invention qui propose en premier lieu un procédé de fabrication d'une structure semiconductrice, qui comprend :
une étape a) de fourniture d'un substrat de silicium S1 ayant une face avant et une face arrière, et
une étape b) qui comprend au moins le dépôt par épitaxie, sur la face avant du substrat S1, d'une couche épaisse de germanium, d'un substrat virtuel de silicium-germanium ou d'un empilement de couches comprenant au moins une couche épaisse de germanium ou au moins un substrat virtuel de silicium-germanium,
et qui est caractérisé en ce qu'il comprend en outre le dépôt, sur la face arrière du substrat S1, d'une couche ou d'une pluralité de couches générant sur cette face arrière des contraintes de flexion qui compensent les contraintes de flexion s'exerçant sur la face avant dudit substrat S1 à l'issue de l'étape b).

Ainsi, conformément à l'invention, on supprime la courbure induite par le dépôt par épitaxie, sur la face avant d'un substrat de silicium, d'une couche épaisse de germanium, d'un substrat virtuel de silicium-germanium ou d'un empilement comprenant au moins une telle couche ou un tel substrat virtuel, ou on prévient la formation d'une telle courbure en déposant, sur la face arrière de ce substrat, une couche ou un ensemble de couches qui créent sur cette face arrière des contraintes de flexion équivalentes à celles qui sont à l'origine de ladite courbure ou qui en seraient à l'origine si ce dépôt en face arrière n'était pas réalisé.

Selon une première disposition avantageuse de l'invention, les contraintes de flexion s'exerçant sur la face avant du substrat S1 sont compensées par le dépôt par épitaxie d'une couche épaisse de germanium ou par le dépôt d'une couche de nitrure de silicium contraint en tension.

Dans ce cas, l'épaisseur de la couche épaisse de germanium ou de la couche de nitrure de silicium contraint en tension est, de préférence, prédéterminée de sorte que son dépôt sur la face arrière du substrat S1 induise une courbure de la structure ayant une flèche de la même taille que la flèche de la courbure induite par les contraintes de flexion s'exerçant sur la face avant du substrat S1 à l'issue de l'étape b) en l'absence de tout dépôt sur la face arrière dudit substrat S1.

Selon une autre disposition avantageuse de l'invention, les contraintes de flexion s'exerçant sur la face avant du substrat S1 sont compensées par le dépôt par épitaxie de plusieurs couches épaisses de germanium ou par le dépôt de plusieurs couches de nitrure de silicium contraint en tension, ces couches étant, de préférence, au nombre de deux.

Dans ce cas, l'épaisseur des couches épaisses de germanium ou des couches de nitrure de silicium contraint en tension est prédéterminée de sorte que leur dépôt sur la face arrière du substrat S1 induise une courbure de la structure ayant une flèche de la même taille que la flèche de la courbure induite par les contraintes de flexion s'exerçant sur la face avant du substrat S1 à l'issue de l'étape b) en l'absence de tout dépôt sur la face arrière dudit substrat S1.

Selon encore une autre disposition avantageuse de l'invention, les contraintes de flexion s'exerçant sur la face avant du substrat S1 sont compensées par le dépôt par épitaxie d'un ou plusieurs substrats virtuels de silicium-germanium ou d'un ensemble de couches comprenant un ou plusieurs substrats virtuels de silicium-germanium.

Cette disposition est particulièrement avantageuse lorsque l'étape b) comprend, elle-même, le dépôt, sur la face avant du substrat S1, d'un ou plusieurs substrats virtuels de silicium-germanium ou d'un ensemble de couches comprenant un ou plusieurs substrats virtuels de silicium-germanium.

Dans ce cas, on compense les contraintes de flexion s'exerçant sur la face avant du substrat S1, de préférence par le dépôt par épitaxie d'une architecture « miroir » de celle déposée sur la face avant de ce substrat S1, c'est-à-dire une architecture qui est identique, tant dans le nombre, la composition et l'épaisseur des couches qui la composent, à celle qui recouvre la face avant du substrat S1 et qui est disposée symétriquement à elle par rapport audit substrat S1.

Dans un premier mode de réalisation préféré du procédé selon l'invention :
l'étape b) comprend le dépôt par épitaxie, sur la face avant du substrat S1, d'un substrat virtuel de silicium-germanium dont la couche de composition constante présente une concentration en germanium de 20 à 50% environ,
et les contraintes de flexion s'exerçant sur la face avant du substrat S1 à l'issue de l'étape b) sont compensées soit par le dépôt d'une ou plusieurs couches de nitrure de silicium contraint en tension, soit par le dépôt par épitaxie d'une ou plusieurs couches épaisses de germanium, ou d'un substrat virtuel de silicium-germanium identique à celui déposé sur la face avant du substrat S1 et disposé symétriquement à lui par rapport audit substrat S1.

Dans un deuxième mode de réalisation préféré du procédé selon l'invention :
l'étape b) comprend le dépôt par épitaxie, sur la face avant du substrat S1, d'un empilement comprenant à partir de ce substrat et dans cet ordre :
   - un substrat virtuel de silicium-germanium dont la couche de composition constante présente une concentration en germanium allant de 20 à 50% environ, et
   - une couche de silicium contraint en tension (sSi),
et les contraintes de flexion s'exerçant sur la face avant du substrat S1 à l'issue de l'étape b) sont compensées soit par le dépôt d'une ou plusieurs couches de nitrure de silicium contraint en tension, soit par le dépôt par épitaxie d'une ou plusieurs couches épaisses de germanium, ou d'un substrat virtuel de silicium-germanium identique à celui déposé sur la face avant du substrat S1 et disposé symétriquement à lui par rapport audit substrat S1.

Dans un troisième mode de réalisation préféré du procédé selon l'invention :
l'étape b) comprend le dépôt par épitaxie, sur la face avant du substrat S1, d'un empilement comprenant à partir de ce substrat et dans cet ordre :
   - un premier substrat virtuel de silicium-germanium dont la couche de composition constante présente une concentration en germanium de 50% environ, et
   - un deuxième substrat virtuel de silicium-germanium dont la couche de composition constante présente une concentration en germanium allant de 60 à 100% environ,
et les contraintes de flexion s'exerçant sur la face avant du substrat S1 à l'issue de l'étape b) sont compensées soit par le dépôt d'une ou plusieurs couches de nitrure de silicium contraint en tension, soit par le dépôt par épitaxie d'une ou plusieurs couches épaisses de germanium, ou d'un empilement identique à celui déposé sur la face avant du substrat S1 et disposé symétriquement à lui par rapport audit substrat S1.

Dans un quatrième mode de réalisation préféré du procédé selon l'invention :
l'étape b) comprend le dépôt par épitaxie, sur la face avant du substrat S1, d'un empilement comprenant à partir de ce substrat et dans cet ordre :
   - un premier substrat virtuel de silicium-germanium dont la couche de composition constante présente une concentration en germanium de 50% environ,
   - un deuxième substrat virtuel de silicium-germanium dont la couche de composition constante présente une concentration en germanium allant de 60 à 100% environ, et
   - un ensemble formé d'une première couche de silicium ou de silicium-germanium contraint en tension, d'une deuxième couche de germanium contraint en compression, et d'une troisième couche de silicium contraint en tension,
et les contraintes de flexion s'exerçant sur la face avant du substrat S1 à l'issue de l'étape b) sont compensées soit par le dépôt d'une ou plusieurs couches de nitrure de silicium contraint en tension, soit par le dépôt par épitaxie d'une ou plusieurs couches épaisses de germanium, ou d'un empilement identique à celui formé, sur la face avant du substrat S1, par les deux substrats virtuels de silicium-germanium déposés sur cette face avant, et disposé symétriquement à lui par rapport audit substrat S1.

Dans un cinquième mode de réalisation préféré du procédé selon l'invention :
l'étape b) comprend le dépôt par épitaxie, sur la face avant du substrat S1, d'un empilement comprenant à partir de ce substrat et dans cet ordre :
   - un premier substrat virtuel de silicium-germanium dont la couche de composition constante présente une concentration en germanium de 50% environ,
   - un deuxième substrat virtuel de silicium-germanium dont la couche de composition constante présente une concentration en germanium allant de 60 à 100% environ, et
   - un ensemble formé d'une première couche de silicium ou de silicium-germanium contraint en tension, d'une deuxième couche de silicium-germanium contraint en compression ou en tension et d'une troisième couche de silicium contraint en tension,
et les contraintes de flexion s'exerçant sur la face avant du substrat S1 à l'issue de l'étape b) sont compensées soit par le dépôt d'une ou plusieurs couches de nitrure de silicium contraint en tension, soit par le dépôt par épitaxie d'une ou plusieurs couches épaisses de germanium, ou d'un empilement identique à celui formé, sur la face avant du substrat S1, par les deux substrats virtuels de silicium-germanium déposés sur cette face avant, et disposé symétriquement à lui par rapport audit substrat S1.

Il est à noter que le dépôt, sur la face arrière du substrat S1, de la couche ou des couches destinées à compenser les contraintes de flexion s'exerçant sur la face avant de ce substrat peut être effectué avant, après ou au cours de l'étape b) si celle-ci comprend plusieurs opérations de dépôt, ce qui est le cas lorsque l'étape b) comprend le dépôt d'un empilement de couches sur la face avant du substrat S1.

Par ailleurs, lorsqu'on compense les contraintes de flexion s'exerçant sur la face avant du substrat S1 par le dépôt de plusieurs couches épaisses de germanium ou de plusieurs couches de nitrure de silicium contraint en tension, on peut aussi bien déposer ces couches l'une à la suite de l'autre qu'à des stades différents du procédé selon l'invention.

L'invention a également pour objet un procédé de fabrication d'un substrat semiconducteur-sur-isolant, qui comprend :
une étape i) comprenant la mise en oeuvre d'un procédé de fabrication d'une structure semiconductrice tel que précédemment défini, et
une étape ii) comprenant le report par collage moléculaire d'une partie de cette structure sur un substrat de silicium S2.

Ce procédé peut notamment être utilisé pour fabriquer un substrat semiconducteur-sur-isolant comprenant une couche de silicium-germanium non contraint, de concentration en germanium comprise entre 20 et 50%, auquel cas :
l'étape i) comprend la mise en oeuvre d'un procédé de fabrication d'une structure semiconductrice selon le premier mode de réalisation préféré précédemment défini, tandis que
l'étape ii) comprend le report par collage moléculaire, sur le substrat S2, d'une partie de la couche de composition constante du substrat virtuel présent sur la face avant du substrat S1.

Le report par collage moléculaire peut notamment être réalisé par le procédé Smart Cut^{®}, auquel cas, le substrat S2 étant préalablement recouvert d'une couche d'oxyde de silicium, l'étape ii) comprend de préférence :
- le dépôt d'une couche d'oxyde de silicium sur la couche de composition constante du substrat virtuel,
- une implantation ionique dans cette couche pour y constituer une zone fragilisée,
- le collage moléculaire des couches d'oxyde de silicium recouvrant respectivement le substrat S2 et la couche de composition constante du substrat virtuel, et
- le clivage de la structure au niveau de la zone fragilisée, avantageusement par traitement thermique.

Le procédé de fabrication d'un substrat semiconducteur-sur-isolant selon l'invention peut également être utilisé pour fabriquer un substrat comprenant une couche de silicium contraint en tension, auquel cas :
l'étape i) comprend la mise en oeuvre d'un procédé de fabrication d'une structure semiconductrice selon le deuxième mode de réalisation préféré précédemment défini, tandis que
l'étape ii) comprend le report par collage moléculaire, sur le substrat S2, de la couche de silicium contraint en tension présente sur la face avant du substrat S1.

Comme précédemment, le report par collage moléculaire peut notamment être réalisé par le procédé Smart Cut^{®}, auquel cas, le substrat S2 étant préalablement recouvert d'une couche d'oxyde de silicium, l'étape ii) comprend de préférence :
- le dépôt d'une couche d'oxyde de silicium sur la couche de silicium contraint en tension,
- une implantation ionique dans la couche de composition constante du substrat virtuel sous-jacent pour y constituer une zone fragilisée,
- le collage moléculaire des couches d'oxyde de silicium recouvrant respectivement le substrat S2 et la couche de silicium contraint en tension,
- le clivage de la structure au niveau de la zone fragilisée, et
- le retrait de la couche résiduelle de silicium-germanium qui recouvre la couche de silicium contraint en tension.

Il peut aussi être utilisé pour fabriquer un substrat semiconducteur-sur-isolant comprenant une couche de silicium-germanium non contraint, de concentration en germanium supérieure ou égale à 60%, ou une couche de germanium pur non contraint, auquel cas :
l'étape i) comprend la mise en oeuvre d'un procédé de fabrication d'une structure semiconductrice selon le troisième mode de réalisation préféré précédemment défini, tandis que
l'étape ii) comprend le report par collage moléculaire, sur le substrat S2, d'une partie de la couche de composition constante du deuxième substrat virtuel présent sur la face avant du substrat S1.

Là également, le report par collage moléculaire peut notamment être réalisé par le procédé Smart Cut^{®}, auquel cas, le substrat S2 étant préalablement recouvert d'une couche d'oxyde de silicium, l'étape ii) comprend :
- le dépôt d'une couche d'oxyde de silicium sur la couche de composition constante du deuxième substrat virtuel,
- une implantation ionique dans cette couche pour y constituer une zone fragilisée,
- le collage moléculaire des couches d'oxyde de silicium recouvrant respectivement le substrat S2 et la couche de composition constante du deuxième substrat virtuel, et
- le clivage de la structure au niveau de la zone fragilisée.

Il peut encore être utilisé pour fabriquer un substrat semiconducteur-sur-isolant comprenant une couche de germanium contraint en compression, auquel cas :
l'étape i) comprend la mise en oeuvre d'un procédé de fabrication d'une structure semiconductrice selon le quatrième mode de réalisation préféré précédemment défini, tandis que
l'étape ii) comprend le report par collage moléculaire, sur le substrat S2, de l'ensemble formé par la première couche de silicium ou de silicium-germanium contraint en tension, la deuxième couche de germanium contraint en compression et par la troisième couche de silicium contraint en tension, présent sur la face avant du substrat S1.

Il peut en outre être mis à profit pour fabriquer un substrat semiconducteur-sur-isolant comprenant une couche de silicium-germanium contraint en compression ou en tension, auquel cas :
l'étape i) comprend la mise en oeuvre d'un procédé de fabrication d'une structure semiconductrice selon le cinquième mode de réalisation préféré précédemment défini, tandis que
l'étape ii) comprend le report par collage moléculaire, sur le substrat S2, de l'ensemble formé par la première couche de silicium ou de silicium-germanium contraint en tension, la deuxième couche de silicium-germanium contraint en compression ou en tension et par la troisième couche de silicium contraint en tension sur la face avant du substrat S1.

Dans ces deux derniers cas, il est également possible de réaliser le report par collage moléculaire par le procédé Smart Cut^{®}, auquel cas, le substrat S2 étant préalablement recouvert d'une couche d'oxyde de silicium, l'étape ii) comprend :
- le dépôt d'une couche d'oxyde de silicium sur la troisième couche de silicium contraint en tension,
- une implantation ionique dans la couche de composition constante du deuxième substrat virtuel sous-jacent pour y constituer une zone fragilisée,
- le collage moléculaire des couches d'oxyde de silicium recouvrant respectivement le substrat S2 et la troisième couche de silicium contraint en tension,
- le clivage de la structure au niveau de la zone fragilisée, et
- le retrait de la couche résiduelle de silicium-germanium qui recouvre la troisième couche de silicium contraint en tension.

Conformément à l'invention, les substrats S1 et S2 sont, de préférence, choisis parmi les substrats de Si(001), les substrats de Si(100) désorienté de 6° dans une des deux directions cristallines <110>, les substrats de Si(110) et les substrats de Si(111).

Par ailleurs, le substrat S1 est choisi parmi les substrats polis double face lorsque la couche ou les couches de compensation de contraintes déposées sur la face arrière de ce substrat le sont par épitaxie (ce qui est le cas des couches épaisses de germanium et des substrats virtuels de silicium-germanium).

L'invention sera mieux comprise à la lumière du complément de description qui suit et qui se réfère aux figures annexées.

Bien entendu, ce complément de description n'est donné qu'à titre d'illustration de l'objet de l'invention et ne constitue en aucun cas une limitation de cet objet.

### BRÈVE DESCRIPTION DES FIGURES

La figure 1A représente, sous la forme d'une courbe, la taille (en µm) des flèches des courbures présentées par des structures constituées d'un substrat virtuel de SiGe, formé par épitaxie directement sur un substrat de Si(001), en fonction de la concentration en Ge (en %) de la couche de composition constante située au sommet de ce substrat virtuel et, sous la forme d'une croix, la taille (également en µm) des flèches des courbures présentées par des structures constituées d'une couche épaisse de Ge de 2,3 µm d'épaisseur, formée par épitaxie directement sur un substrat de Si(001).

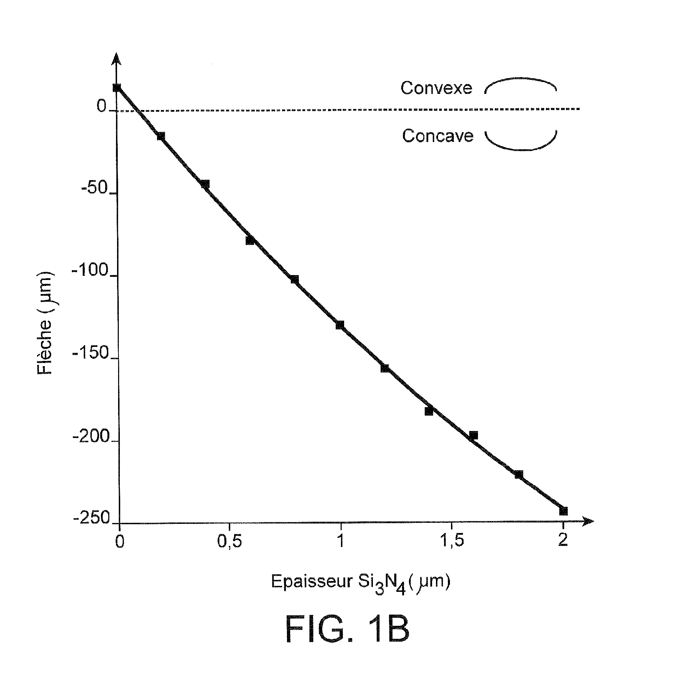

La figure 1B représente, sous la forme d'une courbe, la taille (en µm) des flèches des courbures présentées par des structures constituées d'une couche de nitrure de silicium contraint en tension, formée par épitaxie directement sur un substrat de Si(001), en fonction de l'épaisseur (en µm) de cette couche.

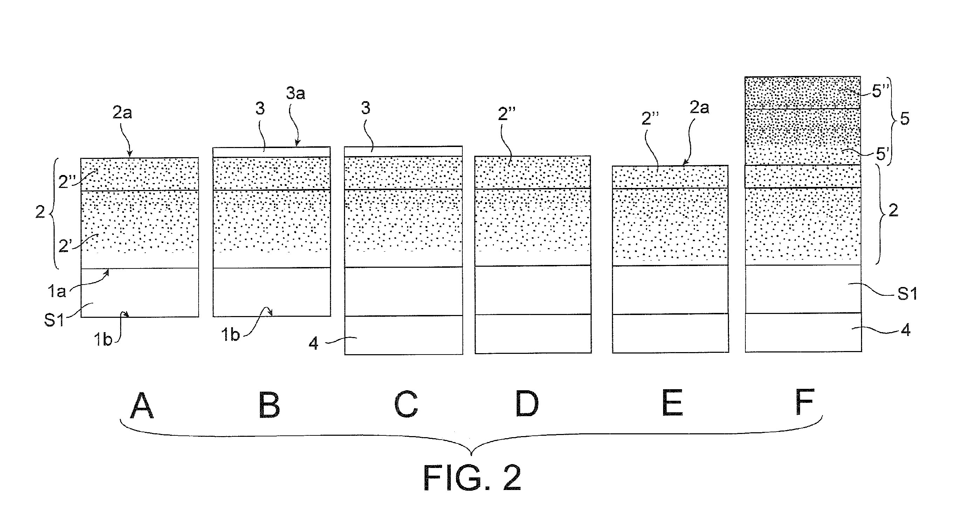

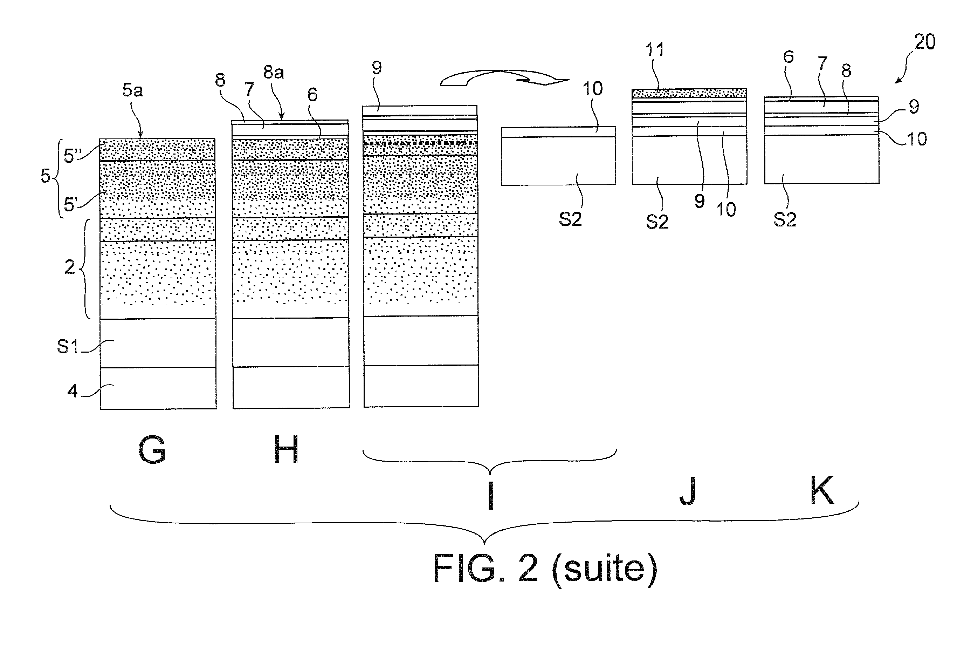

La figure 2, parties A à K, illustre, de façon schématique, les différentes étapes d'un premier mode de mise en oeuvre du procédé de fabrication d'un substrat semiconducteur-sur-isolant selon l'invention, conçu pour fabriquer un substrat sGeOI comprenant une couche de germanium contraint en compression.

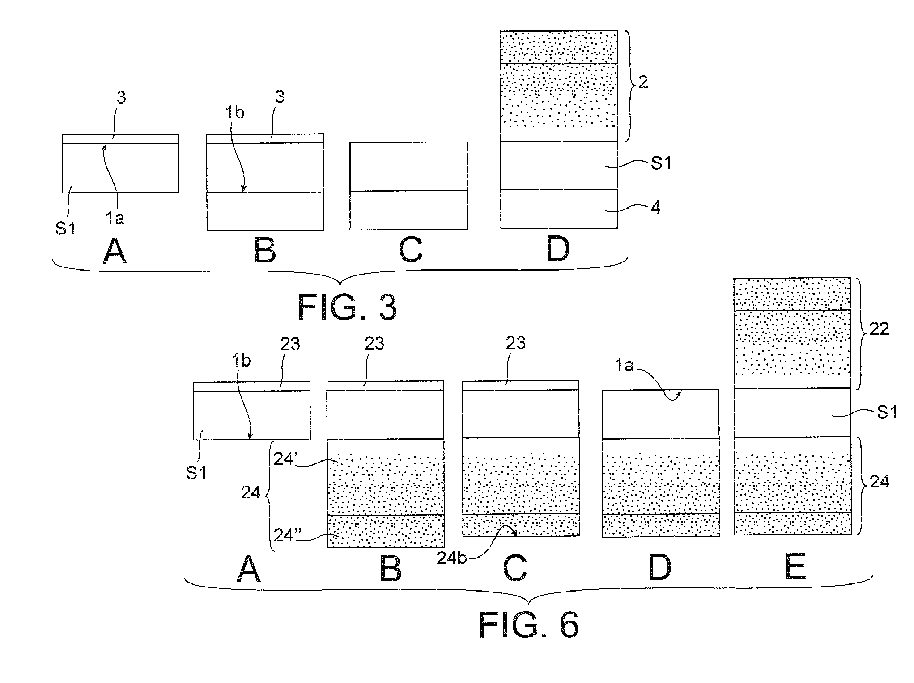

La figure 3, parties A à D, illustre, de façon schématique, les quatre premières étapes d'une première variante du premier mode de mise en oeuvre du procédé de fabrication d'un substrat semiconducteur-sur-isolant selon l'invention, objet de la figure 2.

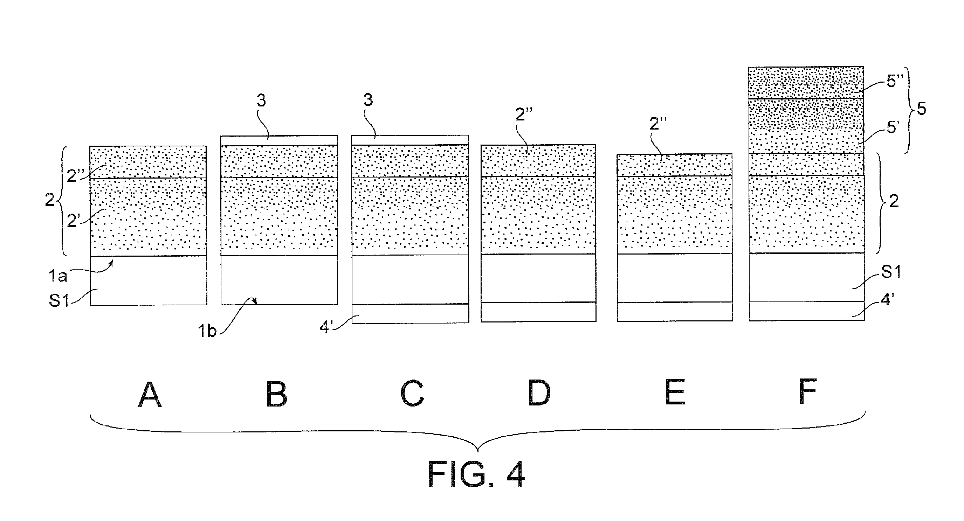

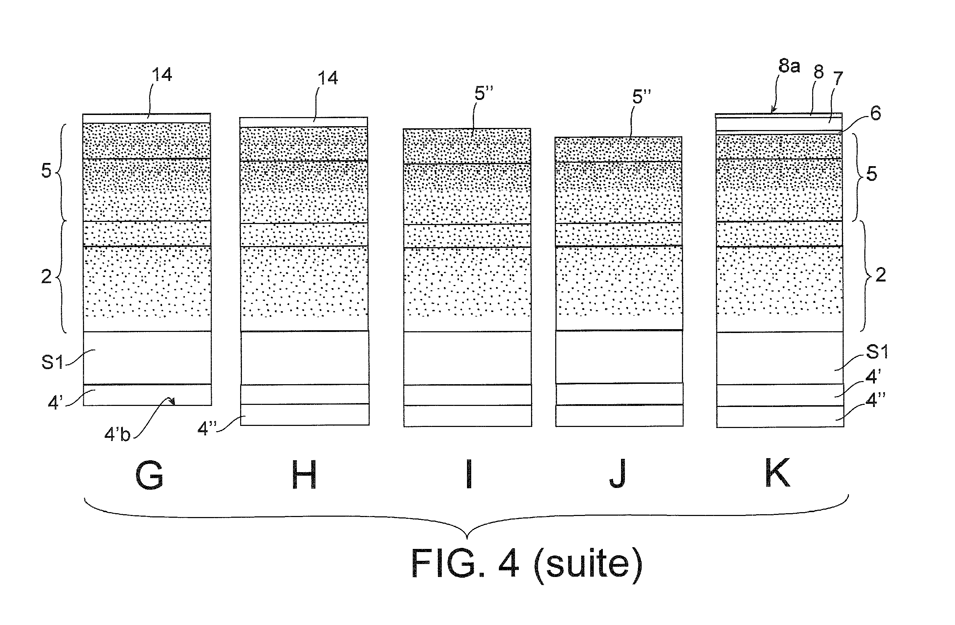

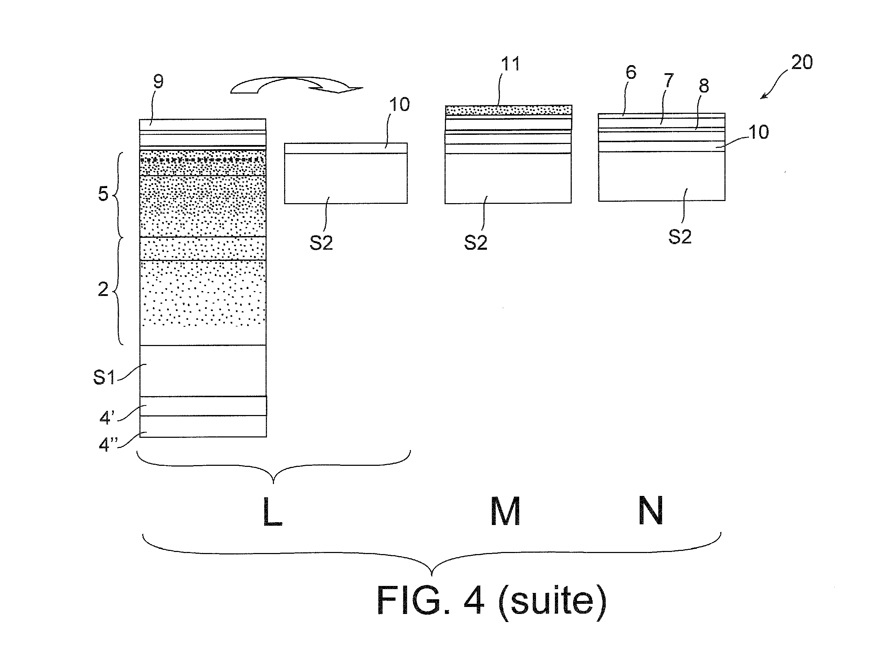

La figure 4, parties A à N, illustre les différentes étapes d'une deuxième variante du premier mode de mise en oeuvre du procédé de fabrication d'un substrat semiconducteur-sur-isolant selon l'invention, objet de la figure 2.

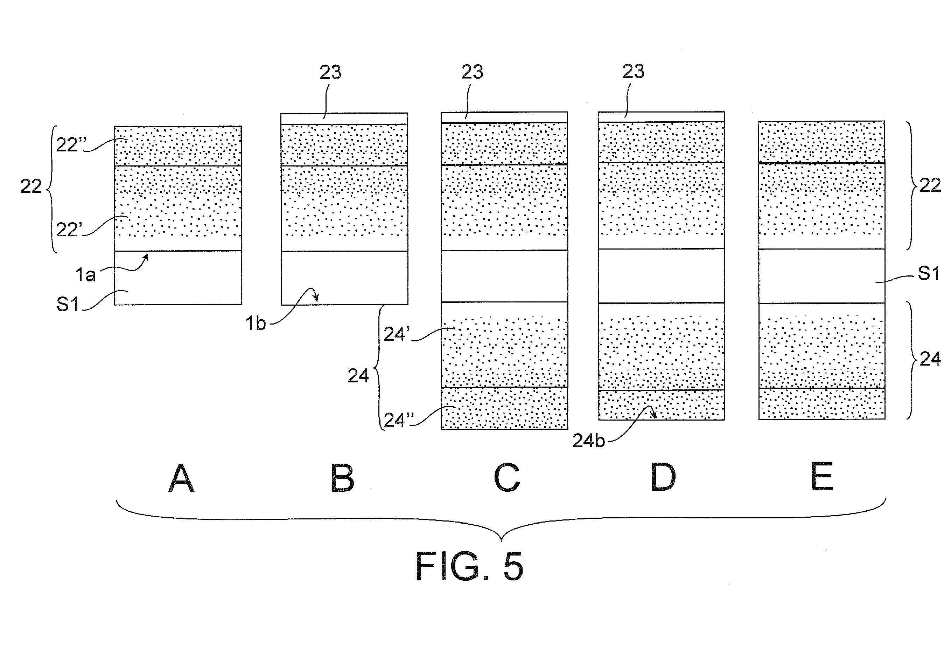

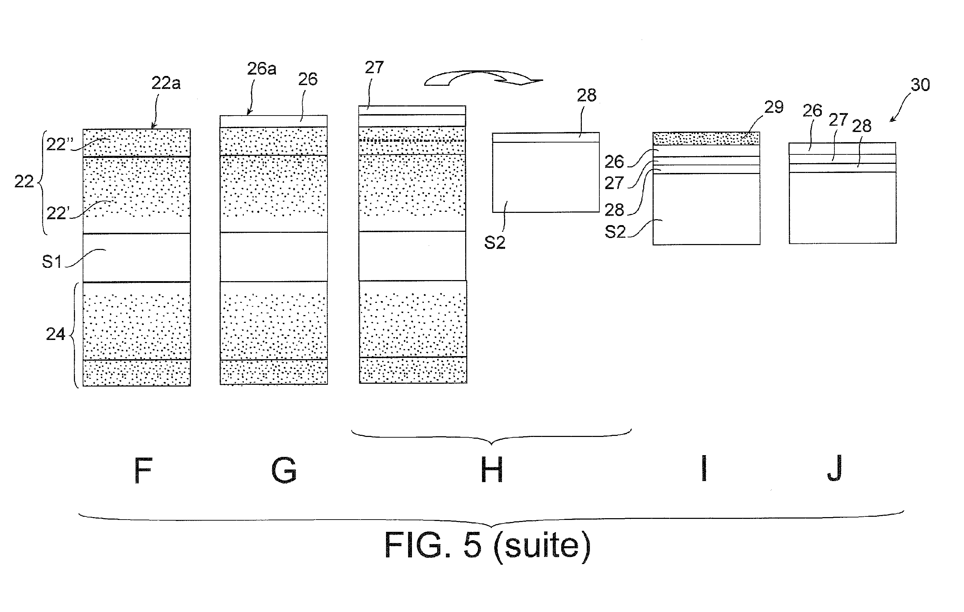

La figure 5, parties A à J, illustre de façon schématique les différentes étapes d'un deuxième mode de mise en oeuvre du procédé de fabrication d'un substrat semiconducteur-sur-isolant selon l'invention, conçu pour fabriquer un substrat XsSOI.

La figure 6, parties A à E, illustre de façon schématique les cinq premières étapes d'une variante du deuxième mode de mise en oeuvre du procédé de fabrication d'un substrat semiconducteur-sur-isolant selon l'invention, objet de la figure 5.

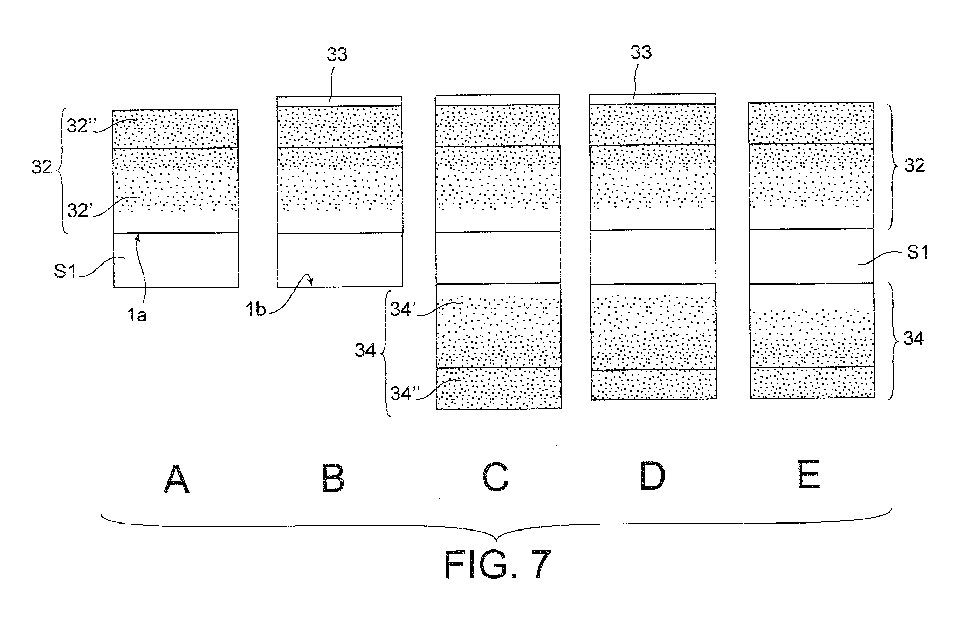

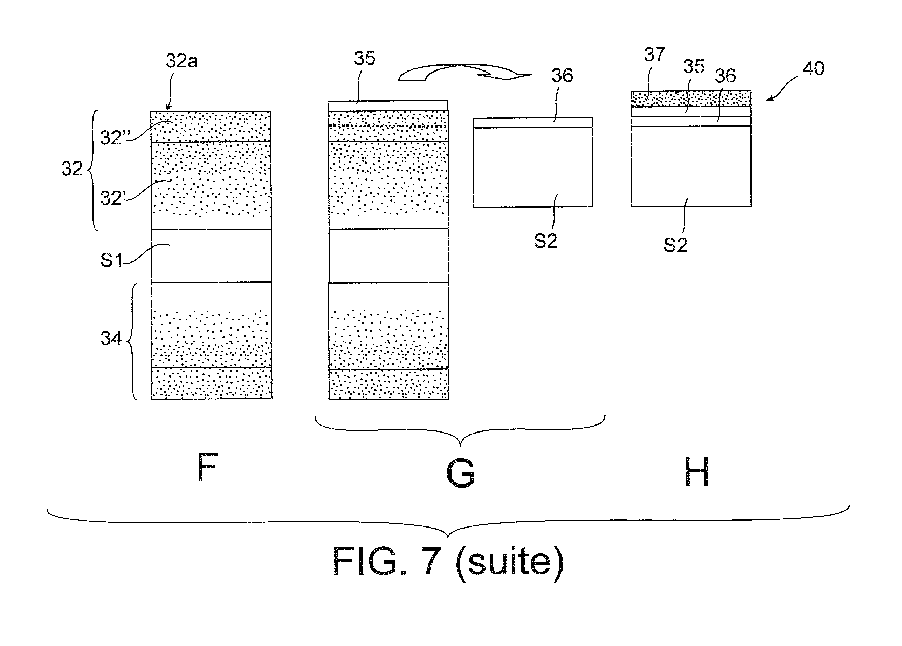

La figure 7, parties A à H, illustre de façon schématique les différentes étapes d'un troisième mode de mise en oeuvre du procédé de fabrication d'un substrat semiconducteur-sur-isolant selon l'invention, conçu pour fabriquer un substrat SiGeOI comprenant une couche de SiGe non contraint, de concentration en Ge inférieure ou égale à 50%.

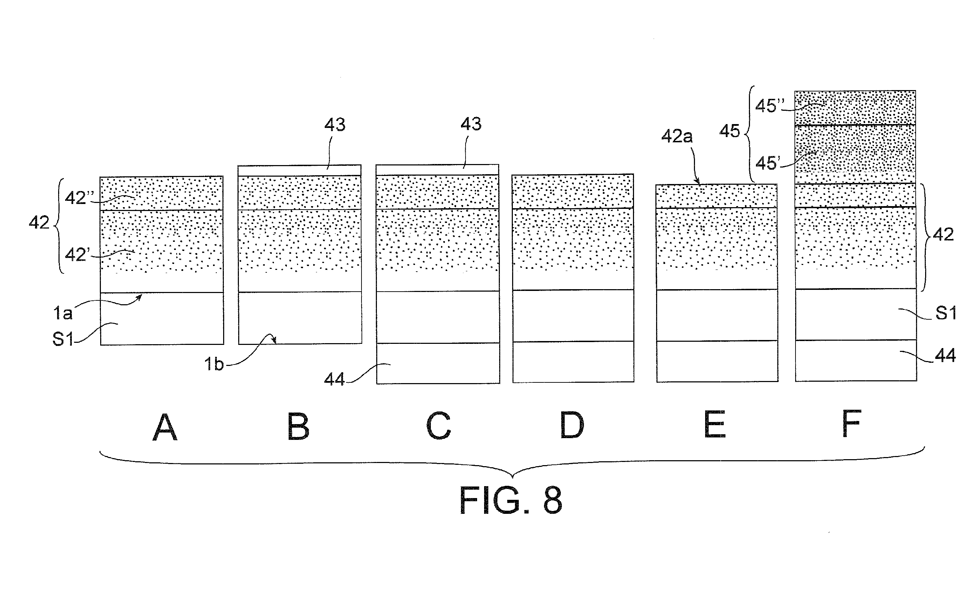

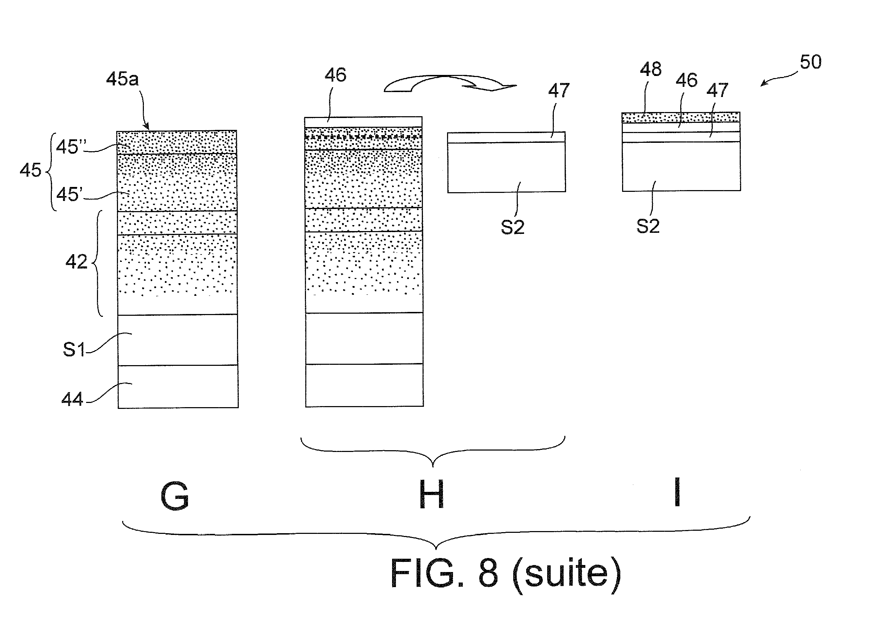

La figure 8, parties A à I, illustre schématiquement les différentes étapes d'un quatrième mode de mise en oeuvre du procédé de fabrication d'un substrat semiconducteur-sur-isolant selon l'invention, conçu pour fabriquer un substrat SiGeOI comprenant une couche de SiGe non contraint, de concentration supérieure à 50%, ou un substrat GeOI comprenant une couche de Ge pur non contraint.

Il est à noter que, par souci de simplification, toutes les structures montrées sur les figures 2 à 8 ont été représentées avec des surfaces planes même lorsqu'elles présentent une courbure concave ou convexe.

### EXPOSÉ DÉTAILLÉ DE MODES DE MISE EN OEUVRE PARTICULIERS

On se réfère tout d'abord à la figure 2 qui illustre schématiquement les différentes étapes d'un premier mode de mise en oeuvre du procédé de fabrication d'un substrat semiconducteur-sur-isolant selon l'invention, conçu pour fabriquer un substrat sGeOI 20 à couche 7 de germanium contraint en compression, et dans lequel la compensation des contraintes de flexion générées en face avant du substrat de silicium sur lequel est formée initialement cette couche est assurée par le dépôt d'une couche épaisse de Ge ou d'une couche de Si₃N₄ contraint en tension en face arrière de ce substrat.

Ce mode de mise en oeuvre comprend tout d'abord le dépôt par épitaxie d'un premier substrat virtuel 2 de SiGe sur la face avant 1a d'un premier substrat S1 de Si (figure 2, partie A).

Le substrat virtuel 2 comprend par exemple :
- comme première couche, une couche 2' de SiGe dont le gradient de concentration en germanium va de quelques % à 50%, avec une rampe de l'ordre de 10% de Ge par µm d'épaisseur, et
- comme deuxième couche, une couche 2" de SiGe à 50% de Ge, de 1 à 2 µm d'épaisseur.

Quant au substrat S1, il s'agit, par exemple, d'une plaque de Si(001), polie simple ou double face, que l'on a préalablement soumise à un ultime nettoyage par voie humide à l'acide fluorhydrique, dit « HF-last » (A. Abbadie et al., Applied Surface Science 225, 256-266, 2005 **[8]**).

Le dépôt par épitaxie du substrat virtuel 2 sur la face avant 1a du substrat S1 peut être réalisé, par exemple, par dépôt chimique en phase vapeur et à pression réduite (RP-CVD), dans des conditions de croissance analogues à celles décrites dans la référence **[2]** précitée.

La structure formée par le substrat S1 et le substrat virtuel 2 présente une courbure concave, c'est-à-dire que la face avant 2a de la couche 2 est concave tandis que la face arrière 1b du substrat 1 est, elle, convexe.

On encapsule alors le substrat virtuel 2 avec une couche 3 de protection (figure 2, partie B), par exemple une couche de SiO₂ que l'on dépose de façon conventionnelle, puis on retourne la structure et, après un nettoyage de type « HF-last » de la face arrière 1b du substrat S1, on dépose sur cette face arrière une couche 4 de compensation de contraintes qui est :
* soit une couche épaisse de Ge, auquel cas le substrat S1 doit être poli sur ses deux faces, et cette couche est déposée par épitaxie, par exemple par RP-CVD en utilisant des conditions de croissance similaires à celles décrites dans la référence **[6],**
* soit une couche de Si₃N₄ contraint en tension, auquel cas le substrat S1 peut n'être poli que sur sa face avant et cette couche est déposée, par exemple, par dépôt chimique en phase vapeur activé par plasma (PE-CVD), les paramètres de dépôt pouvant être une température de l'ordre de 480°C et une chimie de croissance SiH₄ + NH₃ + N₂.

Dans tous les cas, la fonction de cette couche est de compenser à la fois les contraintes de flexion déjà générées en face avant du substrat S1 par le dépôt du substrat virtuel 2 et celles qui seront générées sur cette même face, au cours des étapes illustrées sur la figure 2, parties F et H, par le dépôt de nouvelles couches, l'objectif étant d'obtenir une structure plane, c'est-à-dire exempte de toute courbure, juste avant de procéder au report par collage moléculaire illustré sur la figure 2, parties I et J.

L'épaisseur de la couche 4 est donc préalablement déterminée de sorte que son dépôt en face arrière du substrat S1 conduise à une inversion de la courbure de la structure représentée sur la figure 2, partie B (la face avant 3a de la couche 3 devenant ainsi convexe et la face arrière 1b du substrat S1 devenant ainsi concave), inversion qui doit être d'autant plus prononcée que les contraintes destinées à être générées en face avant de ce substrat au cours des étapes illustrées sur la figure 2, parties F et H, seront plus fortes.

Pour déterminer cette épaisseur, on réalise préalablement, sur un ou plusieurs substrats de Si identiques au substrat S1, les étapes illustrées sur la figure 2, parties A à H, à l'exception de celle qui consiste à déposer la couche 4 en face arrière du substrat S1 et on mesure, par exemple au moyen d'un appareil du type Flexus F2320 de KLA-TENCOR, la taille de la flèche de la courbure affectant l'empilement ainsi obtenu. Puis, on détermine, par exemple à partir d'une courbe de référence que l'on aura préalablement établie en déposant des couches de même nature que la couche 4 que l'on souhaite déposer (c'est-à-dire de Ge ou de Si₃N₄ contraint en tension selon le cas) mais d'épaisseur variable sur des substrats de Si, également identiques au substrat S1, et en mesurant la taille des flèches des courbures ainsi obtenues, l'épaisseur que doit présenter ladite couche 4 pour induire une courbure ayant une flèche de la même taille que celle présentée par cet empilement.

Un exemple d'une courbe susceptible de servir de courbe de référence, ayant été établie en déposant une couche de Si₃N₄ contraint en tension, d'épaisseur variable, sur des substrats de Si(001) par PE-CVD (Température de dépôt : 480°C ; chimie de croissance : SiH₄ + NH₃ + N₂) est montrée, à titre illustratif, sur la figure 1B.

Une fois le dépôt de la couche 4 effectué, on retourne à nouveau la structure qui est, alors, conforme à celle représentée sur la figure 2, partie C.

On retire la couche 3 de protection (figure 2, partie D), par exemple par dissolution à l'acide fluorhydrique.

Puis, on supprime, par plusieurs opérations de polissage mécano-chimique (CMP) et de nettoyage associé que l'on réalise, par exemple, comme décrit par Abbadie et al. dans Microelectronic Engineering 83, 1986-1993, 2006 **[9],** les ondulations qui affectent la surface libre de la couche 2" du substrat virtuel 2 et qui sont inhérentes à ce type de substrat, ce qui a pour effet de réduire sensiblement l'épaisseur de cette couche, par exemple de l'ordre de 0,5 µm (figure 2, partie E).

Ensuite, après un nettoyage de type « HF-last » de la face avant 2a de la couche 2" ainsi réduite, on dépose par épitaxie un deuxième substrat virtuel 5 de SiGe sur cette face avant (figure 2, partie F).

Ce deuxième substrat virtuel comprend par exemple :
- comme première couche, une couche 5' de SiGe dont le gradient de concentration en germanium va de 50% à une valeur comprise entre 60 et 90%, avec une rampe de l'ordre de 10% de Ge par µm d'épaisseur, et
- comme deuxième couche, une couche 5" de SiGe qui présente la même concentration en Ge que la concentration maximale en Ge de la couche 5' et qui mesure de 1 à 2 µm d'épaisseur.

L'étape suivante consiste à supprimer de nouveau, par plusieurs opérations de polissage mécano-chimique (CMP) et de nettoyage associé, les ondulations de surface de la couche 5" du substrat virtuel 5, ce qui, là également, a pour effet de réduire sensiblement l'épaisseur de cette couche, par exemple de l'ordre de 0,5 µm (figure 2, partie G).

On nettoie alors la face avant 5a de la couche 5" par un nettoyage de type « HF-last » et on dépose par épitaxie sur cette face un empilement à équilibre de contraintes comprenant une couche 7 de Ge contraint en compression (cGe) intercalée entre deux couches, respectivement 6 et 8, de Si contraint en tension (sSi) (figure 2, partie H).

Le dépôt par épitaxie de cet empilement peut être réalisé, par exemple, par RP-CVD en utilisant des conditions de croissance similaires à celles décrites par Y. Bogumilowicz et al. dans Materials Science and Engineering B 124-125, 113, 2005 **[10]**, étant entendu que les épaisseurs de chacune des couches 6, 7 et 8 qui forment cet empilement sont à adapter en fonction de la concentration en Ge de la couche 5" du substrat virtuel 5 sous-jacent. En effet, plus cette concentration en Ge est élevée, plus l'épaisseur des couches de Si contraint en tension doit être faible et plus l'épaisseur de la couche de Ge contraint en compression peut être élevée.

Ainsi, les épaisseurs maximum envisageables sont typiquement de l'ordre de 5 à 10 nm pour les couches de Si contraint en tension et de 10 nm pour la couche de Ge contraint en compression dans le cas d'un substrat virtuel Si_{0,4}Ge_{0,6}, tandis qu'elles sont typiquement de l'ordre de 2 à 3 nm pour les couches de Si contraint en tension et de quelques dizaines de nm pour la couche de Ge contraint en compression dans le cas d'un substrat virtuel Si_{0,1}Ge_{0,9}.

On procède ensuite à un report de l'empilement sSi/cGe/sSi sur un deuxième substrat S2 de Si(001), préalablement recouvert d'une couche 10 de SiO₂, en utilisant le procédé Smart Cut^{®} (figure 2, parties I et J), c'est-à-dire par :
* dépôt d'une couche 9 de SiO₂ sur la face avant 8a de la couche 8 de sSi,
* implantation ionique avec un pic d'implantation au coeur de la couche 5" du substrat virtuel 5 pour y constituer une zone fragilisée (représentée par des pointillés sur la figure 2, partie I),
* collage moléculaire des deux couches 9 et 10 de SiO₂,
* traitement thermique pour consolider l'interface du collage moléculaire et pour cliver la couche 5" du substrat virtuel 5 au niveau de la zone fragilisée, et
* polissage mécano-chimique de la couche résiduelle 11 de SiGe qui recouvre l'empilement sSi/cGe/sSi ainsi transféré pour rendre la surface de cette couche à peu près lisse.

On retire alors la couche résiduelle 11 de SiGe par gravure avec une solution adaptée, par exemple une solution HF/H₂O₂/CH₃COOH (1/2/3 v/v) comme décrit par Taraschi et al. dans Journal of Vacuum Science and Technology B 20(2), 725-727, 2002 **[11]**, ou bien à l'acide chlorhydrique gazeux dans le bâti d'épitaxie comme décrit par Y. Bogumilowicz et al. dans Semiconductor Science and Technology 20, 127-134, 2005 **[12]**, la couche 6 de sSi servant alors de couche d'arrêt à cette gravure.

On obtient ainsi le substrat sGeOI 20 à couche 7 de germanium contraint en compression qui est montré sur la figure 2, partie K.

On se réfère à présent à la figure 3 qui illustre schématiquement les quatre premières étapes d'une première variante du premier mode de mise en oeuvre du procédé de fabrication d'un substrat semiconducteur-sur-isolant décrit ci-avant, variante dans laquelle la compensation des contraintes de flexion générées en face avant du substrat S1 au cours de l'élaboration du substrat sGeOI 20 est réalisée avant le dépôt du premier substrat virtuel 2 et non après.

Ainsi, dans cette variante et comme visible sur la figure 3, partie A, on commence par déposer la couche de protection 3 sur la face avant 1a du substrat S1.

Puis, après avoir retourné la structure ainsi obtenue et soumis la face arrière 1b du substrat S1 à un nettoyage de type « HF-last », on dépose la couche 4 sur cette face arrière, après quoi on retourne à nouveau la structure qui est, alors, conforme à celle représentée sur la figure 3, partie B.

On retire alors la couche 3 de protection (figure 3, partie C) et, après un nettoyage de type « HF-last » de la face avant 1a du substrat S1, on dépose le substrat virtuel 2 sur cette face avant (figure 3, partie D).

On exécute ensuite les mêmes étapes que celles illustrées sur la figure 2, parties E à K.

On se réfère à présent à la figure 4 qui illustre schématiquement les différentes étapes d'une deuxième variante du premier mode de mise en oeuvre du procédé de fabrication d'un substrat semiconducteur-sur-isolant décrit ci-avant, variante dans laquelle la compensation des contraintes de flexion générées en face avant du substrat 1 au cours de l'élaboration du substrat sGeOI 20 est réalisée en deux temps.

En effet, il se peut que le fait de compenser l'ensemble des contraintes de flexion générées en face avant du substrat S1 pendant l'élaboration du substrat sGeOI 20 par le dépôt d'une seule couche épaisse de Ge par épitaxie ou d'une seule couche de Si₃N₄ contraint en tension, comme décrit précédemment, conduise à une inversion de courbure de la structure telle que celle-ci rende difficile l'exécution des étapes ultérieures, notamment pour des raisons de manipulation dans les équipements.

Dans ce cas, il est préférable de compenser ces contraintes en déposant deux couches épaisses de Ge par épitaxie ou deux couches de Si₃N₄ contraint en tension, l'une après le dépôt du premier substrat virtuel 2 de SiGe, l'autre après le dépôt du deuxième substrat virtuel 5 de SiGe.

Ainsi, après avoir déposé par épitaxie le premier substrat virtuel 2 de SiGe sur la face avant 1a du substrat S1 de Si et encapsulé ce substrat virtuel avec la couche 3 de protection (figure 4, parties A et B) de la même façon que précédemment décrit, on dépose, sur la face arrière 1b du substrat S1, une première couche 4' de compensation de contraintes (figure 4, partie C) dont l'épaisseur est prédéterminée de sorte que son dépôt ne fasse que compenser les contraintes générées par le dépôt du substrat virtuel 2, ou surcompense ces contraintes mais sans toutefois inverser de manière trop prononcée la courbure concave que présente la structure montrée sur la figure 4, partie B.

On obtient donc, à l'issue du dépôt de la première couche 4', une structure plane ou affectée d'une courbure très légèrement convexe.

On retire ensuite la couche 3 de protection (figure 4, partie D), on supprime les ondulations de surface de la couche 2' du substrat virtuel 2 (figure 4, partie E) par des opérations de CMP et de nettoyage associé, et on dépose par épitaxie le substrat virtuel 5 (figure 4, partie F) de la même façon que précédemment décrit, à l'issue de quoi la structure ainsi obtenue présente de nouveau une courbure concave.

On encapsule alors le substrat virtuel 5 avec une couche 14 de protection (figure 4, partie G), par exemple une couche de SiO₂, puis on dépose, sur la face arrière 4'b de la première couche 4' de compensation de contraintes, une deuxième couche 4" de compensation de contraintes (figure 4, partie H) de même nature qu'elle (Ge ou Si₃N₄ contraint en tension selon le cas) et dont l'épaisseur correspond à la différence entre l'épaisseur qu'aurait présenté une couche épaisse de Ge ou une couche de Si₃N₄ contraint en tension, si celle-ci avait été destinée à compenser toutes les contraintes de flexion générées en face avant du substrat S1 au cours de l'élaboration du substrat sGeOI 20, et l'épaisseur de la première couche 4'.

Une fois le dépôt de la deuxième couche 4" de compensation de contraintes effectué, on retire la couche 14 de protection (partie I de la figure 4), par exemple par dissolution à l'acide fluorhydrique, puis on exécute exactement les mêmes étapes que celles illustrées sur la figure 2, parties G à K (figure 4, parties J à N).

On se réfère à présent à la figure 5 qui illustre schématiquement les différentes étapes d'un deuxième mode de mise en oeuvre du procédé de fabrication d'un substrat semiconducteur-sur-isolant selon l'invention, conçu pour fabriquer un substrat XsSOI 30, c'est-à-dire un substrat comprenant une couche 26 de Si contraint en tension (sSi) élaboré à partir d'un substrat virtuel de SiGe dont la couche de composition constante présente une concentration en Ge supérieure ou égale à 30%, et dans lequel la compensation des contraintes de flexion générées en face avant du substrat de silicium sur lequel est formée initialement la couche 26 est assurée par le dépôt d'un empilement miroir en face arrière de ce substrat.

Comme dans le mode de mise en oeuvre précédent, on commence par déposer par épitaxie un substrat virtuel 22 de SiGe sur la face avant 1a d'un premier substrat S1 de Si (figure 5, partie A).

Dans ce cas, le substrat virtuel 22 comprend :
- comme première couche, une couche 22' de SiGe dont le gradient de concentration en germanium va de quelques % à une valeur comprise entre 20 et 50%, avec une rampe de l'ordre de 10% de Ge par µm d'épaisseur, et
- comme deuxième couche, une couche 22" de SiGe qui présente la même concentration en Ge que la concentration maximale en Ge de la première couche 22' et qui mesure de 1 à 2 µm d'épaisseur,
   que l'on dépose, par exemple, par RP-CVD en utilisant des conditions de croissance analogues à celles décrites dans la référence **[2]** précitée.

Le substrat S1 est, lui, par exemple, une plaque de Si(001), polie double face, que l'on a préalablement soumise à un ultime nettoyage de type « HF-last ».

Puis, on encapsule le substrat virtuel 22 avec une couche 23 de protection (figure 5, partie B), par exemple une couche de SiO₂.

On retourne la structure et, après un nettoyage de type « HF-last » de la face arrière 1b du substrat S1, on forme sur cette face arrière un empilement miroir de celui qui est destiné à recouvrir la face avant 1a du substrat S1 à l'issue de l'étape illustrée sur la figure 5, partie F, l'objectif étant, là également, d'obtenir une structure exempte de toute courbure juste avant de procéder au report par collage moléculaire illustré sur la figure 5, parties H et I.

Or, l'empilement qui est destiné à recouvrir la face avant 1a du substrat S1 à l'issue de l'étape illustrée sur la figure 5, partie F, se compose :
■ de la couche 22' du substrat virtuel 22, et
■ de ce qui restera de la couche 22" de ce substrat virtuel une fois que l'on aura supprimé, à l'étape montrée sur la figure 5, partie G, ses ondulations de surface par des opérations de CMP et de nettoyage associé, soit environ 0,5 µm de la couche 22" d'origine.

L'empilement miroir est donc l'empilement que l'on obtint :
* en déposant par épitaxie sur la face arrière 1b du substrat S1 un substrat virtuel 24 de SiGe comprenant des couches 24' et 24" respectivement identiques, tant dans leur composition que dans leur épaisseur, aux couches 22' et 22" du substrat virtuel 22 (figure 5, partie C), puis
* en supprimant les ondulations de surface de la couche 24" du substrat virtuel 24 (figure 5, partie D) dans des conditions identiques à celles destinées à être utilisées pour supprimer celles de la couche 22" du substrat virtuel 22.

Une fois l'empilement miroir déposé, on retourne à nouveau la structure qui est, alors, conforme à celle représentée sur la figure 5, partie D.

On retire la couche 23 de protection (figure 5, partie E), on supprime les ondulations de surface du substrat virtuel 22 (figure 5, partie F) et on dépose la couche 26 de sSi (figure 5, partie G).

Cette couche 26 peut être déposée, par exemple, par RP-CVD en utilisant des conditions analogues à celles décrites par J. M. Hartmann et al. dans Semiconductor Science and Technology 22, 354-361, 2007 **[13]** ainsi que dans Semiconductor Science and Technology 22, 362-368, 2007 **[14]**.

Son épaisseur, qui peut aller de 10 à 100 nm, est à adapter en fonction des applications auxquelles est destinée le substrat XsSOI 30 et, surtout, de la concentration en Ge de la couche 22" du substrat virtuel 22 sous-jacent. En effet, plus cette concentration est élevée, plus il est souhaitable de réduire l'épaisseur de la couche 26, comme enseigné par les références **[13]** et **[14]** précitées.

On procède alors à un report de la couche 26 de sSi sur un deuxième substrat S2 de Si(001), préalablement recouvert d'une couche 28 de SiO₂, en utilisant le procédé Smart Cut^{®} (figure 5, parties H et I), c'est-à-dire par :
* dépôt d'une couche 27 de SiO₂ sur la face avant 26a de la couche 26 de sSi,
* implantation ionique avec un pic d'implantation au coeur de la couche 22" du substrat virtuel 22 pour y constituer une zone fragilisée (représentée par des pointillés sur la figure 5, partie H),
* collage moléculaire des deux couches 27 et 28 de SiO₂,
* traitement thermique pour consolider l'interface du collage moléculaire et pour cliver la couche 22" du substrat virtuel 22 au niveau de la zone fragilisée,
* polissage mécano-chimique de la couche résiduelle 29 de SiGe qui recouvre la couche 26 de sSi pour rendre la surface de cette couche de SiGe à peu près lisse.

Après avoir retiré la couche résiduelle 29 de SiGe, on obtient le substrat XsSOI 30 qui est montré sur la figure 5, partie J.

On se réfère à présent à la figure 6, parties A à E, qui illustre schématiquement les différentes étapes d'une variante du deuxième mode de mise en oeuvre du procédé de fabrication d'un substrat semiconducteur-sur-isolant qui vient d'être décrit, variante dans laquelle la compensation des contraintes de flexion générées en face avant du substrat S1 de Si au cours de l'élaboration du substrat XsSOI 30 est réalisée avant le dépôt du substrat virtuel 22.

Ainsi, dans cette variante et comme visible sur la figure 6, partie A, on commence par déposer la couche de protection 23 sur la face avant 1a du substrat 1.

Puis, on retourne la structure et, après un nettoyage de type « HF-last » de la face arrière 1b du substrat S1, on dépose par épitaxie le substrat virtuel 24 sur cette face arrière (figure 6, partie B) et on supprime les ondulations de surface de la couche 24" du substrat virtuel 24 (figure 6, partie C) par des opérations de CMP et de nettoyage associé.

On retourne à nouveau la structure et on retire la couche 23 de protection (figure 6, partie D) et, après un nettoyage de type « HF-last » de la face avant 1a du substrat S1, on dépose par épitaxie le substrat virtuel 22 sur cette face avant (figure 6, partie E).

On exécute ensuite les mêmes étapes que celles illustrées sur la figure 5, parties F à J.

On se réfère à présent à la figure 7, parties A à H, qui illustre schématiquement les différentes étapes d'un troisième mode de mise en oeuvre du procédé de fabrication d'un substrat semiconducteur-sur-isolant selon l'invention, conçu pour fabriquer un substrat SiGeOI 40 comprenant une couche 38 de SiGe non contraint, de concentration en Ge inférieure ou égale à 50%, et dans lequel la compensation des contraintes de flexion générées en face avant du substrat de silicium sur lequel est formée initialement cette couche est assurée par le dépôt d'un empilement miroir en face arrière de ce substrat.

Ce mode de mise en oeuvre commence comme celui illustré sur la figure 5 par :
- le dépôt par épitaxie, sur la face avant 1a d'un premier substrat S1 de Si, par exemple une plaque de Si(001), polie double face, d'un premier substrat virtuel 32 de SiGe comprenant une première couche 32' à gradient de concentration en germanium allant de quelques % à 20-50%, avec une rampe de l'ordre de 10% de Ge par µm d'épaisseur, et une deuxième couche 32" de SiGe, de 1 à 2 µm d'épaisseur, ayant la même concentration en Ge que la concentration maximale en Ge de la première couche 32' (figure 7, partie A), puis
   ■ l'encapsulation du substrat virtuel 32 avec une couche 33 de protection, par exemple une couche de SiO₂ (figure 7, partie B), puis
   ■ la formation sur la face arrière 1b du substrat S1 d'un empilement miroir de celui qui est destiné à recouvrir la face avant 1a de ce substrat à l'issue de l'étape illustrée sur la figure 7, partie F, l'objectif étant, là encore, d'obtenir une structure plane juste avant de procéder au report par collage moléculaire illustré sur la figure 7, parties G et H.

Toutefois, dans ce cas, l'empilement qui est destiné à recouvrir la face avant 1a du substrat S1 à l'issue de l'étape illustrée sur la figure 7, partie F, se compose :
■ de la couche 32' du substrat virtuel 32, et
■ de ce qui restera de la couche 32" de ce substrat virtuel une fois que l'on aura supprimé ses ondulations de surface par des opérations de CMP et de nettoyage associé, soit environ 0,5 µm de la couche 32" d'origine.

L'empilement miroir déposé en face arrière du substrat S1 est donc obtenu en déposant par épitaxie, sur la face arrière 1b de ce substrat, un substrat virtuel 34 de SiGe comprenant des couches 34' et 34" respectivement identiques, tant dans leur composition que dans son épaisseur, aux couches 32' et 32" du substrat virtuel 32 (figure 7, partie C), puis en supprimant les ondulations de surface de la couche 34" du substrat virtuel 34 (figure 7, partie D) dans des conditions identiques à celles destinées à être utilisées pour supprimer celles de la couche 32" du substrat virtuel 32.

Une fois l'empilement miroir déposé, on retourne à nouveau la structure qui est, alors, conforme à celle représentée sur la figure 7, partie D.

On retire la couche 33 de protection (figure 7, partie E) et on supprime les ondulations de surface de la couche 32" du substrat virtuel 32 (figure 7, partie F) par des opérations de CMP et de nettoyage associé.

On procède ensuite à un report d'une partie de la couche 32" du substrat virtuel 32 sur un deuxième substrat S2 de Si(001), préalablement recouvert d'une couche 36 de SiO₂, en utilisant le procédé Smart Cut^{®} (figure 7, parties G et H), c'est-à-dire par :
* dépôt d'une couche 35 de SiO₂ sur la face avant 32a de la couche 32" du substrat virtuel 32,
* implantation ionique avec un pic d'implantation au coeur de la couche 32" du substrat virtuel 32 pour y constituer une zone fragilisée (représentée par des pointillés sur la figure 7, partie G),
* collage moléculaire des deux couches 35 et 36 de SiO₂,
* traitement thermique pour consolider l'interface du collage moléculaire et pour cliver la couche 32" du substrat virtuel 32 au niveau de la zone fragilisée, puis
* polissage mécano-chimique de la couche résiduelle 38 de SiGe qui recouvre la couche 35 de SiO₂ pour lisser la surface de cette couche de SiGe.

On obtient ainsi le substrat SiGeOI 40 qui est montré sur la figure 7, partie H, et qui comprend une couche 38 de SiGe non contraint, de concentration en Ge de l'ordre de 20 à 50% et de quelques dizaines de nm d'épaisseur.

On se réfère à présent à la figure 8 qui illustre schématiquement les différentes étapes d'un quatrième mode de mise en oeuvre du procédé de fabrication d'un substrat semiconducteur-sur-isolant selon l'invention, conçu pour fabriquer un substrat 50 SiGeOI à couche 48 de SiGe non contraint, de concentration supérieure à 50%, ou bien un substrat 50 GeOI à couche 48 de Ge pur non contraint, et dans lequel la compensation des contraintes de flexion générées en face avant du substrat de silicium sur lequel est formée initialement la couche 48 est assurée par le dépôt d'une couche épaisse de Ge ou d'une couche de Si₃N₄ contraint en tension en face arrière de ce substrat.

Ce mode de mise en oeuvre comprend comme celui illustré sur la figure 2 :
■ le dépôt par épitaxie, sur la face avant 1a d'un premier substrat S1 de Si, par exemple une plaque de Si(001), polie simple ou double face, d'un premier substrat virtuel 42 de SiGe comprenant une première couche 42' à gradient de concentration en germanium allant de quelques % à 50%, avec une rampe de l'ordre de 10% de Ge par µm d'épaisseur, et une deuxième couche 42" de SiGe à 50% de Ge, de 1 à 2 µm d'épaisseur (figure 8, partie A), puis
■ l'encapsulation de ce substrat virtuel avec une couche 43 de protection, par exemple une couche de SiO₂ (figure 8, partie B), puis
■ le dépôt, sur la face arrière 1b du substrat S1, d'une couche 44 de compensation de contraintes qui peut être une couche épaisse de Ge formée par épitaxie ou une couche de Si₃N₄ contraint en tension (figure 8, partie C), puis
■ le retrait de la couche 43 de protection (figure 8, partie D), puis
■ la suppression des ondulations de surface de la couche 42" du substrat virtuel 42 (figure 8, partie E) par des opérations de CMP et de nettoyage associé, puis
■ le dépôt par épitaxie, sur la face avant 42a de ce substrat virtuel, d'un deuxième substrat virtuel 45 de SiGe, comprenant une première couche 45' à gradient de concentration en germanium allant de 50% à une valeur comprise entre 60 et 100%, avec une rampe de l'ordre de 10% de Ge par µm d'épaisseur, et une deuxième couche 45" de SiGe de 1 à 2 µm d'épaisseur, ayant la même concentration en Ge que la concentration maximale de la couche 45' (figure 8, partie F), puis
■ la suppression des ondulations de surface de la couche 45" du substrat virtuel 45 (figure 8, partie G).

Toutefois, dans ce mode de mise en oeuvre, on ne dépose pas d'empilement à équilibre de contraintes sSi/cGe/sSi de sorte que les contraintes de flexion générées en face avant du substrat S1 se limitent aux contraintes générées par le dépôt des deux substrats virtuels 42 et 45.

L'épaisseur de la couche 44 est donc prédéterminée en conséquence.

On procède ensuite à un report d'une partie de la couche 45" du substrat virtuel 45 sur un deuxième substrat S2 de Si(001), préalablement recouvert d'une couche 47 de SiO₂, en utilisant le procédé Smart Cut^{®} (figure 8, parties H et I), c'est-à-dire par :
* dépôt d'une couche 46 de SiO₂ sur la face avant 45a de la couche 45" du substrat virtuel 45,
* implantation ionique avec un pic d'implantation au coeur de la couche 45" du substrat virtuel 45 pour y constituer une zone fragilisée (représentée par des pointillés sur la figure 8, partie H),
* collage moléculaire des deux couches 46 et 47 de SiO₂,
* traitement thermique pour consolider l'interface du collage moléculaire et pour cliver la couche 45" du substrat virtuel 45 au niveau de la zone fragilisée, puis
* polissage mécano-chimique de la couche résiduelle 48 de SiGe ou de Ge qui recouvre la couche 46 de SiO₂ pour lisser la surface de cette couche de SiGe ou de Ge.

On obtient ainsi le substrat 50 SiGeOI ou GeOI qui est montré sur la figure 8, partie I, et qui comprend une couche 48 soit de SiGe non contraint, de concentration en Ge supérieure à 60%, soit de Ge pur non contraint, dont l'épaisseur est dans tous les cas de quelques dizaines de nm.

Le procédé selon l'invention ne se limite nullement aux modes de mise en oeuvre décrits ci-avant.

Ainsi, par exemple, dans le premier mode de mise en oeuvre illustré sur la figure 2 et ses variantes, il est tout à fait envisageable de remplacer la couche 7 de germanium contraint en compression par une couche de SiGe :
■ soit contraint en compression, auquel cas sa concentration en Ge est au moins égale à la concentration en Ge de la couche 5" du substrat virtuel 5 sous-jacent,
■ soit contraint en tension, auquel cas sa concentration en Ge est inférieure à la concentration en Ge de la couche 5" du substrat virtuel 5 sous-jacent,
en faisant par exemple appel aux points de fonctionnement indiqués par J. M. Hartmann dans *Journal of Crystal Growth* 305, 113, 2007 **[15]**. On peut ainsi moduler la mobilité des porteurs de charge dans ladite couche de SiGe.

Il est également envisageable de remplacer la couche 6 de silicium contraint en tension par une couche de SiGe contraint en tension, de concentration en Ge inférieure à celle de la couche 5" du substrat virtuel 5 sous-jacent de sorte que cette couche de SiGe puisse, comme ladite couche 6 de sSi, servir de couche d'arrêt la gravure.

Par ailleurs, dans tous les modes de réalisation qui viennent d'être décrits, les substrats de silicium(001) peuvent être remplacés par d'autres substrats de silicium comme, par exemple, des substrats de Si (100) désorienté de 6° dans une des deux directions cristallines <110>, de Si(110) ou encore de Si(111).

Enfin, il va de soi que, dans les modes de mise en oeuvre illustrés sur les figures 2, 3, 4 et 8, la compensation des contraintes de flexion générées en face avant des substrats S1 peut être assurée par le dépôt par épitaxie, en face arrière de ces substrats, d'un empilement miroir de celui qui est destiné à recouvrir leur face avant à l'issue des étapes respectivement illustrées sur les figures 2H, 4K et 8G.

Inversement, dans les modes de mise en oeuvre illustrés sur les figures 5, 6 et 7, la compensation des contraintes de flexion générées en face avant des substrats S1 peut être assurée par le dépôt en face arrière de ces substrats d'une ou plusieurs couches épaisses de Ge par épitaxie ou par une ou plusieurs couches de nitrure de silicium en tension.

### REFERENCES CITEES

[1] Y. Bogumilowicz et al., Journal of Crystal Growth 274, 28-37 (2005)
[2] Y. Bogumilowicz et al., Journal of Crystal Growth 283, 346-55 (2005)
[3] Y. Bogumilowicz et al., Journal of Crystal Growth 290, 523-31 (2006)
[4] Y. Bogumilowicz et al., Solid State Phenomena 108-109, 445 (2005)
[5] D. M. Isaacson et al., Journal of Vacuum Science and Technology B 24, 2741-46 (2006)
[6] J. M. Hartmann et al., Journal of Crystal Growth 274, 90 (2005)
[7] L. Clavelier et al., ECS Transactions 3(7), 789 (2006)
[8] A. Abbadie et al., Applied Surface Science 225, 256 (2004)
[9] A. Abbadie et al., Microelectronic Engineering 83, 1986-1993 (2006)
[10] Y. Bogumilowicz et al., Materials Science and Engineering B 124-125, 113 (2005)
[11] Taraschi et al., Journal of Vacuum Science and Technology B 20(2), 725-727 (2002)
[12] Y. Bogumilowicz et al., Semiconductor Science and Technology 20, 127-134 (2005)
[13] J. M. Hartmann et al., Semiconductor Science and Technology 22, 354-361 (2007)
[14] J. M. Hartmann et al., Semiconductor Science and Technology 22, 362-368 (2007)
[15] J. M. Hartmann, Journal of Crystal Growth 305, 113 (2007)

## Revendications

1. Procédé de fabrication d'une structure semiconductrice, comprenant :
une étape a) de fourniture d'un substrat de silicium S1 ayant une face avant et une face arrière, et
une étape b) qui comprend au moins le dépôt par épitaxie, sur la face avant du substrat S1, d'une couche épaisse de germanium, d'un substrat virtuel de silicium-germanium ou d'un empilement de couches comprenant au moins une couche épaisse de germanium ou au moins un substrat virtuel de silicium-germanium,
ledit procédé étant **caractérisé en ce qu'**il comprend en outre le dépôt, sur la face arrière du substrat S1, d'une couche ou d'une pluralité de couches générant sur cette face arrière des contraintes de flexion qui compensent les contraintes de flexion s'exerçant sur la face avant dudit substrat S1 à l'issue de l'étape b).

2. Procédé selon la revendication 1, dans lequel les contraintes de flexion s'exerçant sur la face avant du substrat S1 à l'issue de l'étape b) sont compensées par le dépôt d'une ou plusieurs couches épaisses de germanium par épitaxie ou d'une ou plusieurs couches de nitrure de silicium contraint en tension.

3. Procédé selon la revendication 1, dans lequel les contraintes de flexion s'exerçant sur la face avant du substrat S1 à l'issue de l'étape b) sont compensées par le dépôt par épitaxie d'un ou plusieurs substrats virtuels de silicium-germanium ou d'un ensemble de couches comprenant un ou plusieurs substrats virtuels de silicium-germanium.

4. Procédé selon la revendication 3, dans lequel les contraintes de flexion s'exerçant sur la face avant du substrat S1 à l'issue de l'étape b) sont compensées par le dépôt par épitaxie d'une architecture miroir de celle déposée sur la face avant dudit substrat S1.

5. Procédé selon la revendication 1, dans lequel :
l'étape b) comprend le dépôt par épitaxie, sur la face avant du substrat S1, d'un substrat virtuel de silicium-germanium dont la couche de composition constante présente une concentration en germanium de 20 à 50% environ,
et les contraintes de flexion s'exerçant sur la face avant du substrat S1 à l'issue de l'étape b) sont compensées soit par le dépôt d'une ou plusieurs couches de nitrure de silicium contraint en tension, soit par le dépôt par épitaxie d'une ou plusieurs couches épaisses de germanium, ou d'un substrat virtuel de silicium-germanium identique à celui déposé sur la face avant du substrat S1 et disposé symétriquement à lui par rapport audit substrat S1.

6. Procédé selon la revendication 1, dans lequel :
l'étape b) comprend le dépôt par épitaxie, sur la face avant du substrat S1, d'un empilement comprenant à partir de ce substrat et dans cet ordre :
- un substrat virtuel de silicium-germanium dont la couche de composition constante présente une concentration en germanium allant de 20 à 50% environ, et
- une couche de silicium contraint en tension (sSi),
et les contraintes de flexion s'exerçant sur la face avant du substrat S1 à l'issue de l'étape b) sont compensées soit par le dépôt d'une ou plusieurs couches de nitrure de silicium contraint en tension, soit par le dépôt par épitaxie d'une ou plusieurs couches épaisses de germanium, ou d'un substrat virtuel de silicium-germanium identique à celui déposé sur la face avant du substrat S1 et disposé symétriquement à lui par rapport audit substrat S1.

7. Procédé selon la revendication 1, dans lequel :
l'étape b) comprend le dépôt par épitaxie, sur la face avant du substrat S1, d'un empilement comprenant à partir de ce substrat et dans cet ordre :
- un premier substrat virtuel de silicium-germanium dont la couche de composition constante présente une concentration en germanium de 50% environ, et
- un deuxième substrat virtuel de silicium-germanium dont la couche de composition constante présente une concentration en germanium allant de 60 à 100% environ,
et les contraintes de flexion s'exerçant sur la face avant du substrat S1 à l'issue de l'étape b) sont compensées soit par le dépôt d'une ou plusieurs couches de nitrure de silicium contraint en tension, soit par le dépôt par épitaxie d'une ou plusieurs couches épaisses de germanium, ou d'un empilement identique à celui déposé sur la face avant du substrat S1 et disposé symétriquement à lui par rapport audit substrat S1.

8. Procédé selon la revendication 1, dans lequel :
l'étape b) comprend le dépôt par épitaxie, sur la face avant du substrat S1, d'un empilement comprenant à partir de ce substrat et dans cet ordre :
- un premier substrat virtuel de silicium-germanium dont la couche de composition constante présente une concentration en germanium de 50% environ,
- un deuxième substrat virtuel de silicium-germanium dont la couche de composition constante présente une concentration en germanium allant de 60 à 100% environ, et
- un ensemble formé d'une première couche de silicium ou de silicium-germanium contraint en tension, d'une deuxième couche de germanium contraint en compression, et d'une troisième couche de silicium contraint en tension,
et les contraintes de flexion s'exerçant sur la face avant du substrat S1 à l'issue de l'étape b) sont compensées soit par le dépôt d'une ou plusieurs couches de nitrure de silicium contraint en tension, soit par le dépôt par épitaxie d'une ou plusieurs couches épaisses de germanium, ou d'un empilement identique à celui formé, sur la face avant du substrat S1, par les deux substrats virtuels de silicium-germanium déposés sur cette face avant, et disposé symétriquement à lui par rapport audit substrat S1.

9. Procédé selon la revendication 1, dans lequel :
l'étape b) comprend le dépôt par épitaxie, sur la face avant du substrat S1, d'un empilement comprenant à partir de ce substrat et dans cet ordre :
- un premier substrat virtuel de silicium-germanium dont la couche de composition constante présente une concentration en germanium de 50% environ,
- un deuxième substrat virtuel de silicium-germanium dont la couche de composition constante présente une concentration en germanium allant de 60 à 100% environ, et
- un ensemble formé d'une première couche de silicium ou de silicium-germanium contraint en tension, d'une deuxième couche de silicium-germanium contraint en compression ou en tension et d'une troisième couche de silicium contraint en tension,
et les contraintes de flexion s'exerçant sur la face avant du substrat S1 à l'issue de l'étape b) sont compensées soit par le dépôt d'une ou plusieurs couches de nitrure de silicium contraint en tension, soit par le dépôt par épitaxie d'une ou plusieurs couches épaisses de germanium, ou d'un empilement identique à celui formé, sur la face avant du substrat S1, par les deux substrats virtuels de silicium-germanium déposés sur cette face avant, et disposé symétriquement à lui par rapport audit substrat S1.

10. Procédé de fabrication d'un substrat semiconducteur-sur-isolant, qui comprend :
une étape i) comprenant la mise en oeuvre d'un procédé de fabrication d'une structure semiconductrice tel que défini dans l'une quelconque des revendications 1 à 9, et
une étape ii) comprenant le report par collage moléculaire d'une partie de cette structure sur un substrat de silicium S2.

11. Procédé selon la revendication 10, dans lequel, le substrat semiconducteur-sur-isolant comprenant une couche de silicium-germanium non contraint, de concentration en germanium comprise entre 20 et 50%,
l'étape i) comprend la mise en oeuvre d'un procédé tel que défini dans la revendication 5, tandis que
l'étape ii) comprend le report par collage moléculaire, sur le substrat S2, d'une partie de la couche de composition constante du substrat virtuel présent sur la face avant du substrat S1.

12. Procédé selon la revendication 11, dans lequel, le substrat S2 étant préalablement recouvert d'une couche d'oxyde de silicium, l'étape ii) comprend :
- le dépôt d'une couche d'oxyde de silicium sur la couche de composition constante du substrat virtuel,
- une implantation ionique dans cette couche pour y constituer une zone fragilisée,
- le collage moléculaire des couches d'oxyde de silicium recouvrant respectivement le substrat S2 et la couche de composition constante du substrat virtuel, et
- le clivage de la structure au niveau de la zone fragilisée.

13. Procédé selon la revendication 10, dans lequel, le substrat semiconducteur-sur-isolant comprenant une couche de silicium contraint en tension,
l'étape i) comprend la mise en oeuvre d'un procédé tel que défini dans la revendication 6, tandis que
l'étape ii) comprend le report par collage moléculaire, sur le substrat S2, de la couche de silicium contraint en tension présente sur la face avant du substrat S1.

14. Procédé selon la revendication 13, dans lequel, le substrat S2 étant préalablement recouvert d'une couche d'oxyde de silicium, l'étape ii) comprend :
- le dépôt d'une couche d'oxyde de silicium sur la couche de silicium contraint en tension,
- une implantation ionique dans la couche de composition constante du substrat virtuel sous-jacent pour y constituer une zone fragilisée,
- le collage moléculaire des couches d'oxyde de silicium recouvrant respectivement le substrat S2 et la couche de silicium contraint en tension,
- le clivage de la structure au niveau de la zone fragilisée, et
- le retrait de la couche résiduelle de silicium-germanium qui recouvre la couche de silicium contraint en tension.

15. Procédé selon la revendication 10, dans lequel, le substrat semiconducteur-sur-isolant comprenant une couche de silicium-germanium non contraint, de concentration en germanium supérieure ou égale à 60%, ou une couche de germanium pur non contraint,
l'étape i) comprend la mise en oeuvre d'un procédé tel que défini dans la revendication 7, tandis que
l'étape ii) comprend le report par collage moléculaire, sur le substrat S2, d'une partie de la couche de composition constante du deuxième substrat virtuel présent sur la face avant du substrat S1.

16. Procédé selon la revendication 15, dans lequel, le substrat S2 étant préalablement recouvert d'une couche d'oxyde de silicium, l'étape ii) comprend :
- le dépôt d'une couche d'oxyde de silicium sur la couche de composition constante du deuxième substrat virtuel,
- une implantation ionique dans cette couche pour y constituer une zone fragilisée,
- le collage moléculaire des couches d'oxyde de silicium recouvrant respectivement le substrat S2 et la couche de composition constante du deuxième substrat virtuel, et
- le clivage de la structure au niveau de la zone fragilisée.

17. Procédé selon la revendication 10, dans lequel, le substrat semiconducteur-sur-isolant comprenant une couche de germanium contraint en compression,
l'étape i) comprend la mise en oeuvre d'un procédé tel que défini dans la revendication 8, tandis que
l'étape ii) comprend le report par collage moléculaire, sur le substrat S2, de l'ensemble formé par la première couche de silicium ou de silicium-germanium contraint en tension, la deuxième couche de germanium contraint en compression et par la troisième couche de silicium contraint en tension, présent sur la face avant du substrat S1.

18. Procédé selon la revendication 10, dans lequel, le substrat semiconducteur-sur-isolant comprenant une couche de silicium-germanium contraint en compression ou en tension,
l'étape i) comprend la mise en oeuvre d'un procédé tel que défini dans la revendication 9, tandis que
l'étape ii) comprend le report par collage moléculaire, sur le substrat S2, de l'ensemble formé par la première couche de silicium ou de silicium-germanium contraint en tension, la deuxième couche de silicium-germanium contraint en compression ou en tension et par la troisième couche de silicium contraint en tension sur la face avant du substrat S1.

19. Procédé selon la revendication 18, dans lequel, le substrat S2 étant préalablement recouvert d'une couche d'oxyde de silicium, l'étape ii) comprend :
- le dépôt d'une couche d'oxyde de silicium sur la troisième couche de silicium contraint en tension,
- une implantation ionique dans la couche de composition constante du deuxième substrat virtuel sous-jacent pour y constituer une zone fragilisée,
- le collage moléculaire des couches d'oxyde de silicium recouvrant respectivement le substrat S2 et la troisième couche de silicium contraint en tension,
- le clivage de la structure au niveau de la zone fragilisée, et
- le retrait de la couche résiduelle de silicium-germanium qui recouvre la troisième couche de silicium contraint en tension.
